# EUROPEAN PATENT APPLICATION

(11) **EP 2 540 863 A1**
(43) Date of publication of application: **02.01.2013**
(21) Application number: 10846412.4
(22) Date of filing: 23.02.2010
(51) Int. Cl.: C23C 16/46, C23C 16/24, C30B 25/10

(54) **CVD PROCESSING METHOD AND CVD DEVICE USING SAID METHOD**

(71) Applicant: Teoss CO., LTD., Tokyo 185-0012 (JP)
(72) Inventor: MURAI, Tsuyoshi, Kokubunji-shi Tokyo 185-0012 (JP); KONAKA, Toshinori, Kokubunji-shi Tokyo 185-0012 (JP); SUZUKI, Masayuki, Kokubunji-shi Tokyo 185-0012 (JP)
(74) Representative: Waldren, Robin Michael
(86) International application number: PCT/JP2010/001168
(87) International publication number: WO 2011/104740

(57) **Abstract**

A method for CVD processing, comprises the steps of: fixing both ends of a silicon substrate (S) to a pair of electrode mounts (28a), (28b) ; lowering a resistance value of the silicon substrate (S) by raising temperature of the silicon substrate (S) with heat from an outer heater (23) provided outside the case (14); heating the silicon substrate (S) to a temperature at which the CVD process can be started by applying electrical current, and lowering an atmosphere temperature in the CVD space (66) by stopping the outer heater (23); and forming a thin film on a surface of the silicon substrate (S) by injecting source gas (G) into the CVD space (66), when the silicon substrate (S) is heated to the temperature at which the CVD process can be started and the atmosphere temperature in the CVD space (66) is lowered to a predetermined temperature.

## Description

### Field of the Invention

The present invention relates to a method for processing a chemical vapor deposition (CVD) for forming thin films on silicon substrates and a CVD device using the same.

### Description of the Related Art

Chemical vapor deposition process is a chemical process used to produce thin films, for example epitaxial films, on silicon substrates by gas phase reaction in a gas phase or heat decomposition. The patent Document 1, Japanese Laid-Open Patent Publication No. 2004-315930, discloses an example of a CVD device for a CVD process using the heat decomposition.

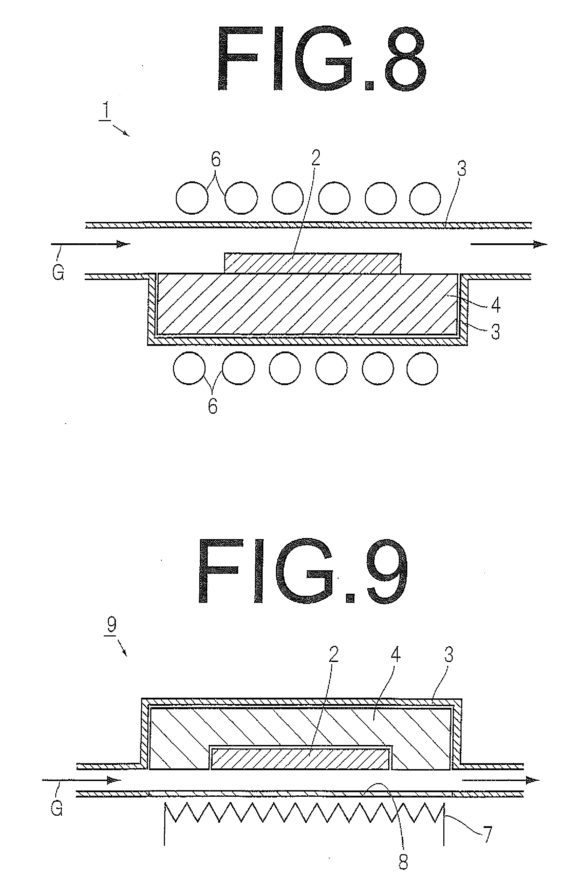

The CVD device 1 according to the Patent Document 1 consists of a casing 3; a carbon susceptor 4 provided in the casing 3; and a high frequency induction heater 6 heating the carbon susceptor 4. A silicon substrate 2 is set in the casing 3, as shown in FIG.8.

According to the CVD device 1, a Si (silicon) thin film can be formed on the surface of the silicon substrate 2 with the Si from the heat decomposed source gas. The process consists of steps: putting the silicon substrate 2 on the upper surface of the carbon susceptor 4 in the casing 3; heating the carbon susceptor 4 with the high frequency induction heater 6; heating the silicon substrate 2 with the heated carbon susceptor 4 to 600 to 1300 degrees C, which the CVD process can be started; supplying the source gas G, for example silane "SiH₄", into the casing 3; and decomposing the source gas G "SiH₄ to Si + 2H₂."

Material of the source gas G can be selected on the basis of required component of the thin film formed on the surface of the silicon substrate 2. When Si thin film is required, SiHCl₃+H₂, SiH₂Cl₂+H₂, or SiCl₄+H₂ can be used instead of the silane as described above. See the following reaction formulas.

SiH₄ -> Si 2H₂

SiHCl₃ + H₂ → Si + 3HCl

SiH₂Cl₂ + H₂ → Si + 2HCl + H₂

SiCl₄ + 2H₂ → Si + 4HCl

In addition, as shown in FIG. 9, a CVD device 9 heating the silicon substrate 2 to a temperature, at which the CVD process can be started, by giving heat from an electric heater 7 through a quartz glass board 8 instead of the high frequency induction heater 6 in the CVD device 1 is developed.

### Summary of the Invention

The CVD devices 1, 9 include some problems that: the thin film is also formed elsewhere than the silicon substrate, a long time is required for the CVD process, and miniaturization of the CVD device is difficult.

The reason is that the carbon susceptor 4 must be heated by the high frequency induction heater 6 for heating the silicon substrate 2 set in the casing 3 from room temperature to the temperature, at which the CVD process can be started. Radiation heat from the carbon susceptor 4 cannot heat the silicon substrate 2 selectively. In other words, the radiation heat must heat from the carbon susceptor 4 heats all components including the carbon susceptor 4 and the casing 3.

In the conventional CVD devices 1, 9, all components are heated. Crystalline silicon films, therefore, are formed not only on the silicon substrates 2 but on surfaces of the carbon susceptor 4 and the quartz glass board 8 of the CVD device 9 needlessly.

Because the silicon film formed on the surface of the carbon susceptor 4 and the quartz glass board 8 is adhered strongly, it is almost impossible to remove the film physically. Furthermore, when the silicon film formed solidly on the surface layer, or oxidized silicon (SiO₂) layer, of the quartz glass board 8 is chemically removed, the quartz glass board 8 is devitrified as if the surface is roughed. Consequently, a replacement of the quartz glass board 8 is required, because it is difficult to give radiation heat from the electric heater 7 through such a roughed quartz glass board 8.

Furthermore, in the CVD device 1 and the CVD device 9, to elevate the temperature of the silicon substrate 2 to predetermined temperature, an amount of heat from the carbon susceptor 4 required only for the silicon substrate 2 is far from enough. It is further required an amount of heat for whole system including the casing 3 and loss that is radiated from an outer surface of the casing 3. Consequently, it is required a long time for temperature elevating, so that the CVD process time can not be shortened.

The high frequency induction heater 6 and the electric heater 7 of the CVD device 1 and the CVD device 9 must have a large amount of capacity that can radiate the heat for the whole system including the silicon substrate 2 and the heat for the loss to outside of the system, as described above. Consequently, it is difficult to reduce in size of the CVD device 1 and 9 including the high frequency induction heater 6 and the electric heater 7.

This invention is developed in view of the problems of the conventional CVD device. The main issue of this invention is to minimize the possibility that a film is formed at a place except the surface of the silicon substrate and is to shorten the CVD processing time by shortening the temperature elevating time for the silicon substrate and is to provide the CVD device using the CVD processing method that can minimize size of CVD device.

According to the first aspect of the present invention, a method for CVD processing, comprises the steps of:
fixing both ends of a silicon substrate S to a pair of electrode mounts 28a, 28b spaced out within a CVD space 66 in a case 14;
lowering a resistance value of the silicon substrate S by raising a temperature of the silicon substrate S with heat from an outer heater 23 provided outside the case 14;
heating the silicon substrate S to a temperature that the CVD process can be started by applying electrical current through the electrode mounts 28a, 28b, and lowering an atmosphere temperature in the CVD space 66 by stopping the outer heater 23; and
forming a thin film on a surface of the silicon substrate S by injecting source gas G into the CVD space 66, when the silicon substrate S is heated to the temperature at which the CVD process can be started and the atmosphere temperature in the CVD space 66 is lowered to a predetermined temperature.

A highly pure silicon substrate S, for example eleven nines, has very high electric resistance value at room temperature, because of its high purity. The lower the resistance value is, the higher the temperature of the silicon substrate S is. For example, the resistance value around 700 degrees C is several ohms, and around 800 degree C is lower than one ohm. Applying electric current to the silicon substrate S causes a decrease of the resistance value. Joule heat is generated by the electric current and the electric resistance of the silicon substrate S. This Joule heat can heat only the silicon substrate S selectively, because the Joule heat is generated at the silicon substrate itself unlike radiation heat from the outer heater 23.

The method for the CVD processing of the present invention takes this point into consideration. Then the method comprises the steps of: lowering the resistance value of the silicon substrate S to an applicable value, for example 600 to 800 degrees C, by heating the silicon substrate S with the outer heater 23 provided outside the case 14; heating only the silicon substrate S by applying electrical current to the temperature that the CVD process can be started, for example a temperature for the epitaxial film forming process, and lowering the atmosphere temperature in the CVD space 66 to e.g. 600 degrees C by stopping the outer heater 23; and injecting source gas G into the CVD space 66.

According to this method, the thin film is formed on the surface of the silicon substrate S heated to the temperature, at which the CVD process can be started, by thermal decomposition of the source gas G near the surface of the silicon substrate S. And the thin film is not formed at a needless area by lowering the temperature of the members, for example the case 14 and the electrode mounts 28a, 28b, except the silicon substrate S.

The atmosphere temperature" of the CVD space 66 means a temperature at a position in the CVD space 66 except the silicon substrate S. It is preferred to determine the "atmosphere temperature" at a position near an inner surface of the case 14, i.e. a surface abutting on the CVD space 66, for avoiding surely forming a thin film on the inner surface of the case 14.

Furthermore, in the present invention, only the silicon substrate S is heated to the temperature, at which the CVD process can be started. Required heating capacity can be smaller than that for the conventional CVD devices, with reduction of required heating time. Consequently, CVD process time can be shortened.

Furthermore, the smaller the required heating capacity is, the smaller a size of an electric power-supply apparatus supplying to the outer heater 23 is. This results in that the size of the CVD device 10 is minimized.

Any judgment methods for determining timing to apply the current to the silicon substrate S can be selected. For example, the application of current to the silicon substrate S may be started automatically by keeping application of voltage across both ends of the silicon substrate S before the heating of the silicon substrate S with the outer heater 23 is started. The heated silicon substrate S shows lowered resistance value, so that the application of current is started automatically at a certain temperature, or a certain resistance value. The current may be applied to the silicon substrate S manually at a certain temperature; it is necessary to examine a relation between the temperature and the resistance value of the silicon substrate S. And the application of the current may start based on an elapsed time from an activation of the outer heater 23 or the resistance value of the silicon substrate S.

The outer heater 23 for decreasing an atmosphere temperature of the CVD space 66 may be stopped simultaneously with the start of the application of the current to the silicon substrate S. The outer heater 23 may be stopped, when the temperature of the silicon substrate S reaches the temperature at which the CVD process can be started. In the latter case, the current through the silicon substrate S must be adjusted so as to keep the temperature at which the CVD process can be started until the time that the atmosphere temperature of the CVD space 66 is lowered to a predetermined temperature after stopping the outer heater 23.

The voltage across the silicon substrate S may be applied simultaneously with heating the silicon substrate S with the outer heater 23.

By applying the voltage across the silicon substrate S before heating, the application of current through the silicon substrate S is started automatically. While the silicon substrate S is cold and low resistance value, the current is not applied. But decrease of the resistance value of the silicon substrate S by heating with the outer heater 23 causes the application of current to the silicon substrate S naturally.

As described above, in case of applying the voltage across the silicon substrate S in advance or simultaneously with heating the silicon substrate S, a manual application of the current to the silicon substrate S based on the temperature or the resistance value is not necessary. Consequently, the rise in temperature proceeds smoothly, and thermometers and resistance meters to detect the timing for the application of the current are not required.

According to the second aspect of the present invention, a CVD device 10 comprises:
a case 14 having a CVD space 66 inside and being connected to a source gas supply pipe 18 supplying a source gas to the CVD space 66;
an outer heater 23 provided outside of the case 14;
a pair of electrode mounts 28a, 28b spaced out within the CVD space 66 and retaining both ends of a silicon substrate S for applying the CVD process; and
an electric power-supply apparatus 24 applying current to the silicon substrate S through the electrode mounts 28a, 28b and supplying electric power to the outer heater 23,
wherein the electric power-supply apparatus 24 has a controller 126 which heats electrically the silicon substrate S to certain temperature at which the CVD process can be started by heating the silicon substrate S with the outer heater 23 following reduction of resistance value of the silicon substrate S, and reduces an atmosphere temperature of the CVD space 66 by stopping the outer heater 23 before a supply of source gas (G) to the CVD space 66 through the source gas supply pipe 18.

The controller 126 may apply a voltage across the silicon substrate S when the silicon substrate S begins to be heated with the outer heater 23.

The CVD device 10 may further comprises a thermometer 22 measuring temperature of the silicon substrate S and transmitting the measured temperature to the controller 126,
wherein the controller 126 begins to apply the current through the silicon substrate S, when the silicon substrate S reaches at certain temperature.

According to the present invention, by heating only the silicon substrate selectively to the temperature at which the CVD process can be started, the possibility of unnecessary formation of the thin film on somewhere except on the surface of the silicon substrate is minimized. And by reducing the heating time, the CVD process time can be shortened. Furthermore, the size of the CVD device is minimized.

### Brief Description of the Drawings

FIG. 1 is a plan view, partly in section, showing a CVD device of the present invention.
FIG.2 is a front view, partly in section, showing a CVD device of the present invention.
FIG. 3 is a cross-sectional view of FIG. 1 in a longitudinal direction, along the line III-III.
FIG.4 is a cross-sectional view of FIG. 1 in a perpendicular direction to the longitudinal direction, along the line IV-IV.
FIG. 5 is an exploded perspective view showing a silicon substrate mount of the CVD device.
FIG. 6 is an enlarged view showing the silicon substrate mount.
FIG.7 is a graph showing relation between a temperature of the silicon substrate and its resistance value, a current value through the silicon substrate, or a temperature in the CVD space.
FIG.8 shows a conventional art.
FIG. 9 shows a conventional art.

### Description of the Preferred Embodiments

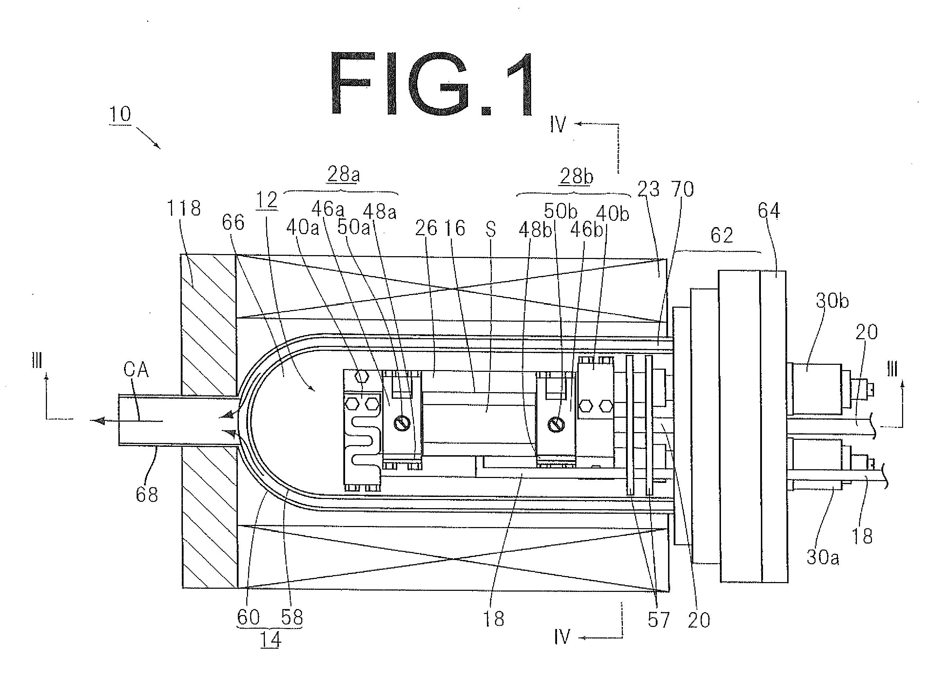

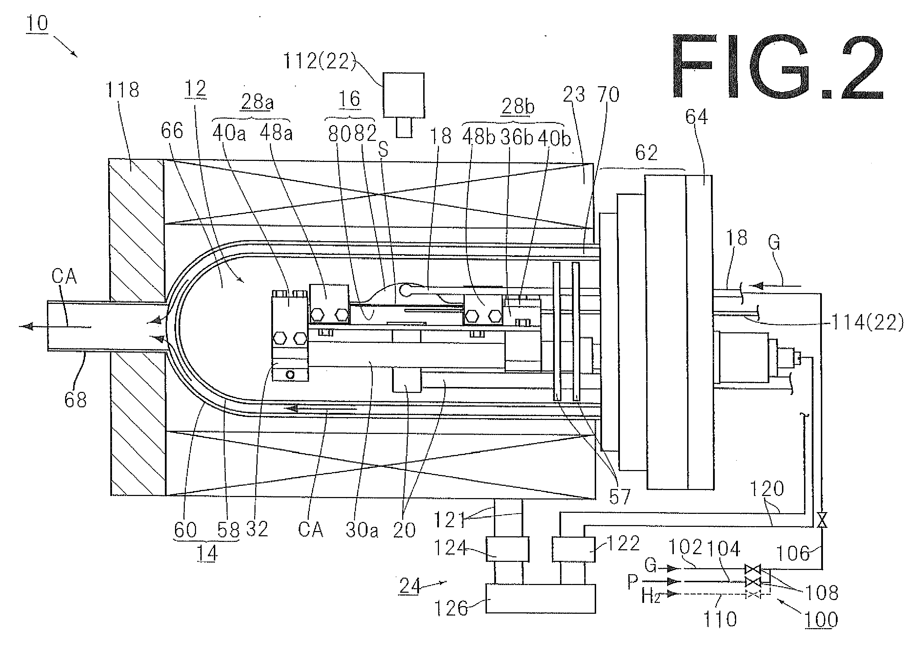

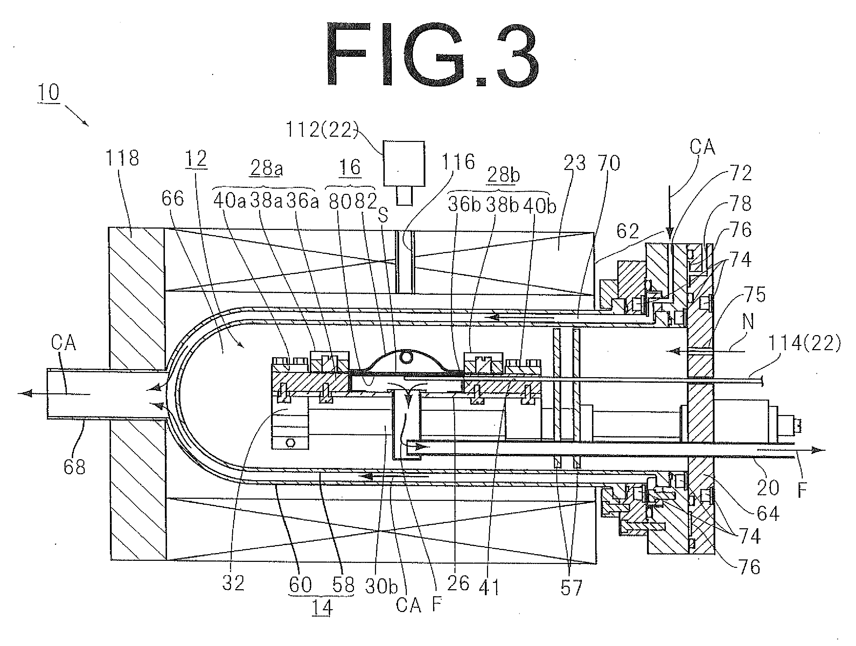

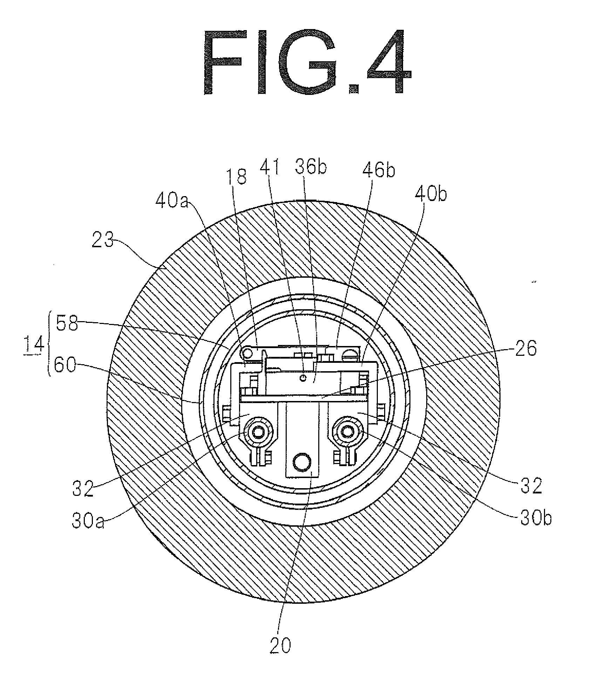

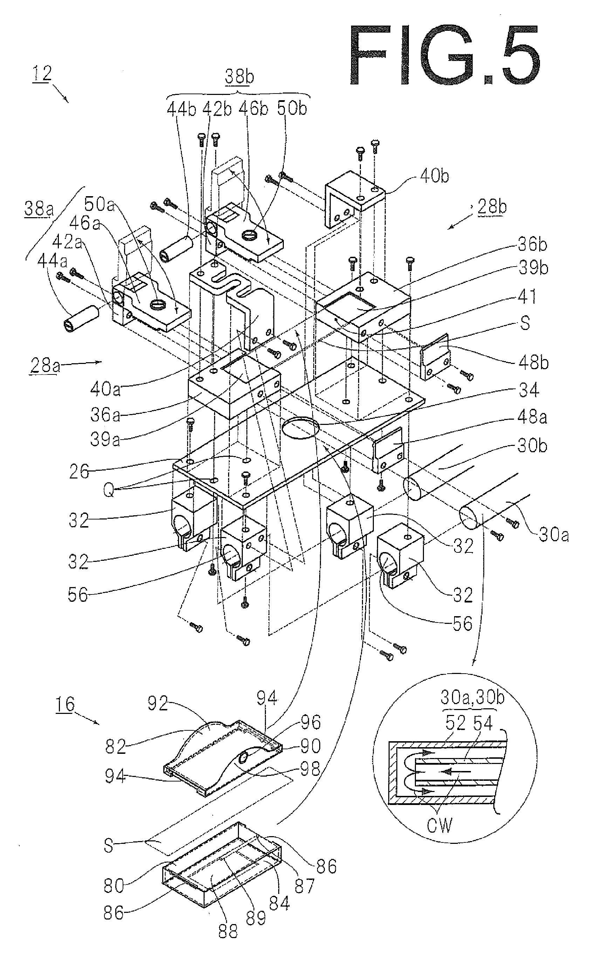

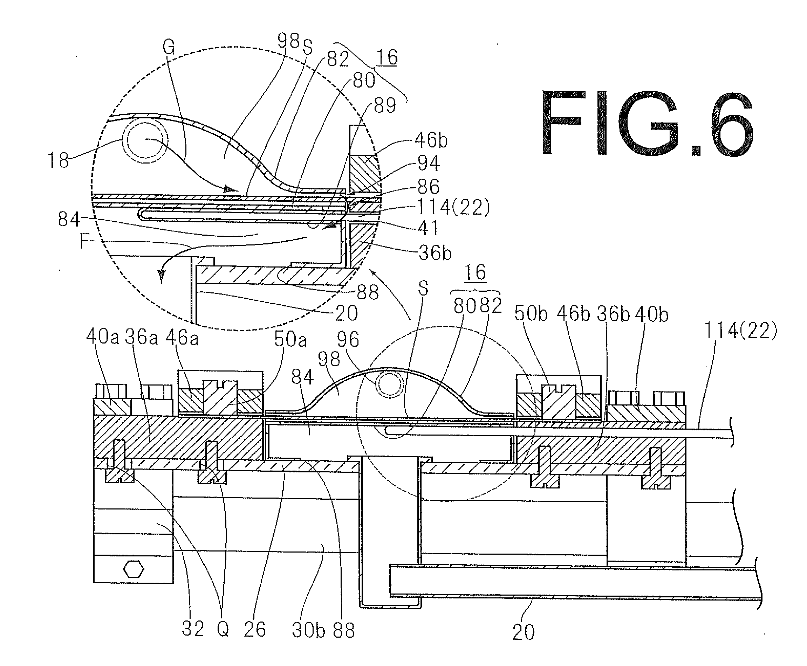

A CVD device 10 according to the present invention is explained with FIG.1 to FIG.6 as below. FIG. 1 is a plan view, looking down view, showing a CVD device 10. In FIG.1 and FIG.2, an outer heater 23 and a cap 118 are illustrated in section view for showing a silicon substrate mount 12 and others contained in the cylindrical outer heater 23. FIG.2 is a front view showing the CVD device 10. FIG.3 is a cross-sectional view of FIG. 1 in a longitudinal direction, along the line III-III. FIG. 4 is a cross-sectional view of FIG.1 in a perpendicular direction to the longitudinal direction, along the line IV-IV. FIG.5 is an exploded perspective view showing a silicon substrate mount 12 of the CVD device 10. And FIG.6 is an enlarged view showing the silicon substrate mount 12.

The CVD device 10 comprises: a silicon substrate mount 12; a case 14; a substrate enclosing case 16; a source gas supply pipe 18; a used source gas discharge pipe 20; a thermometer 22; an outer heater 23; and an electric power-supply apparatus 24.

This CVD device 10 has general-purpose properties for applying thermal chemical vapor deposition to a silicon substrate S. And the CVD device 10 has other properties that the possibility of unnecessary formation of the thin film on somewhere except on the surface of the silicon substrate is minimized, and the size of the CVD device 10 is minimized. Therefore, inside cleaning can be easy, and the CVD process time can be shortened. Furthermore, the CVD device 10 is preferred to the usage for which a small or portable device is required, for example the usage for forming mono-crystal silicon on a sample silicon substrate S for checking a purity of a silane gas, e.g, monosilane, trichlorosilane, dichlorosilane, and silicon tetrachloride.

The silicon substrate mount 12, as shown in FIG. 5 and FIG. 6, retains the silicon substrate S for CVD process and applies the current through the silicon substrate S. And the silicon substrate mount 12 comprises: a base plate 26; a pair of electrode mounts 28a, 28b; a pair of feeder bars 30a, 30b; and a feeder bar mount 32.

The base plate 26 is a reed-shaped transparent board made of quartz glass. And the base plate 26 is provided on the level. The silicon substrate S is mounted on the base plate 26 with the pair of the electrode mounts 28a, 28b. The base plate 26 has some holes for fixing the electrode mounts 28a, 28b and the feeder bar mount 32 with bolts, and a source gas pipe insertion hole 34 for a used source gas discharge pipe 20 at the center of the base plate 26.

Each of the electrode mounts 28a, 28b clamps and retains the end of the silicon substrate S and supplies electric power to the silicon substrate S from the feeder bars 30a, 30b through the feeder bar mounts 32. Because each electrode mount 28a, 28b has almost of the same configuration, common parts are explained collectively. And different points also be explained as needed. Numbers for the parts that have different configurations between each of the electrode mounts 28a, 28b are indicated at Arabic numbers only, when the parts are explained in broader concepts. On the other hand, the numbers with alphabets (lower-case) are indicated, when the differentiation whether the parts belong to which the electrode mounts 28a, 28b is needed. In each figures, the numbers with alphabets (lower-case) are used.

The electrode mount 28a comprises a substrate placing table 36, a substrate holder 38, and a feeder plate 40.

The substrate placing tables 36 are graphite blocks provided on each longitudinal end of the base plate 26 with bolts. Substrate set-in recesses 39 where the silicon substrate S is set in are provided on the end of each substrate placing table 36. One substrate set-in recess 39 faces the other substrate set-in recess 39.

Furthermore, the substrate placing table 36a of one electrode mount 28a has some elongated holes Q for the bolts extended in a longitudinal direction of the base plate 2 6, so that the substrate placing table 36a can be moved slightly in the longitudinal direction of the base plate 26 corresponding to a length of thermal expansion of the silicon substrate S. On the other hand, the substrate placing table 36b of the other electrode mount 28b provided near a blind flange 64 has some circular holes. The substrate placing table 36b has a thermocouple insertion hole 41 (described below) in the longitudinal direction of the substrate placing table 36b in which a thermocouple 114 (described below) is inserted.

The substrate holder 38 clamps the end of the silicon substrate S in cooperation with the substrate placing table36. And the substrate holder 38 comprises a fixedmember 42 fixed on side surface of the substrate placing table36, a pivot member 4 6 pivotally mounted on the fixed member 42 with a pin 44, a latch member 48 retaining the pivot member 46 in a state that the pivot member 46 clamps the silicon substrate S. The latch member 48 is provided on opposite side surface of the substrate placing table36 to the side surface where the latch member 48 is provided.

At each center of the pivot members 46, a substrate push screw 50 is screwed through the pivot member 46. In the state that the pivot members 46 are retained to the latch members 48, tips of the substrate push screws 50 push the surface of the silicon substrate S. Consequently, length of projecting portions of the substrate push screws 50 can be adjusted against change of thickness of the silicon substrate S.

The feeder plate 40 is an L-shaped good conductor made of metal or the like. One end of the feeder plate 40 is attached to the surface of the substrate placing table 36 with bolts; the other end is attached to side surface of the feeder bar mount 32.

In this embodiment, the feeder plate 40b of the other electrode mount 28b has uniform width. On the other hand, the feeder plate 40a of one electrode mount 28a has smaller width and almost S-shape in planar view. When the substrate placing table 36a moves in longitudinal direction by thermal expansion as described above, the almost S-shape feeder plate 40a can be bent easily. Consequently, the one end of the feeder plate 40a attached to the substrate placing table 36a can be moved with the substrate placing table 36a based on the other end attached to the feeder bar mount 32 as a fixed end. When the silicon substrate S shrinks by decrease in temperature, the substrate placing table 36a returns by elasticity of the feeder plate 40a itself.

Each of the feeder bars 30a, 30b is a good conductor bar made of metal or the like and supplies electric power from the electric power-supply apparatus 24 to the silicon substrate S retained by the silicon substrate mount 12. In this embodiment, each of the feeder bars 30a, 30b has a double pipe structure that comprises a closed-end outer pipe 52 and an inner pie 54 inserted into the outer pipe 52. Cooling water CW flows between the outer pipe 52 and the inner pipe 54 after the cooling water CW flows inside the inner pipe54 and turns over in the end of the inner pipe 54.

Each of the feeder bar mounts 32 is a good conductor block made of metal or the like and has a feeder insertion hole 56 provided on its side surface for the insertion of the feeder bar 30a, 30b. In this embodiment, a pair of the feeder bar mounts 32 is provided for each of the feeder bars 30a, 30b; a total of four feeder bar mounts 32 are provided on four corners with bolts on an under surface of the base plate 26. The feeder bar mounts 32 may clamp the feeder bars 30a, 30b by clenching the bolts. The method of fixing the feeder bars 30a, 30b to the feeder bar mounts 32 is not limited to this embodiment.

As just described, the silicon substrate mount 12 integrally comprises: the base plate 26; one pair of the electrode mounts 28a, 29b; one pair of the feeder bar 30a, 30b; the feeder bar mounts 32. As described hereinbelow, the feeder bars 30a, 30b are fixed into the blind flange 64 that constitutes the case 14. Consequently, the silicon substrate mount 12 is suspended in the CVD space 66 of the case 14 by the blind flange 64, when the blind flange 64 is fitted to the flange 62.

Furthermore, if needed, a heat shield 57 may be provided between the base plate 26 and the blind flange 64 (see FIG.1 to 3). In this embodiment, two pieces of frosted glass, or the heat shields 57, are supported from the feeder bars 30a, 30b. The heat shields 57 interfere with transmission of radiation heat from the high-temperature silicon substrate S to the flange 62 and the blind flange 64. Various radiation heat barrier materials may be used for the heat shields 57 as an alternative to the frosted glass. But the frosted glass is preferred on account of non-contamination.

As shown in FIG.1 to 4, the case 14 houses the silicon substrate mount 12 and provides the CVD space 66 for CVD processing to the silicon substrate S. In this embodiment, the case 14 comprises: an inner tube 58; an outer tube 60; a flange 62; and a blind flange 64.

The inner tube 58 is a transparent bottomed round cylinder which is made of quartz glass. The inner tube 58 may be a square cylinder or the like. And the inner tube 58 has a silicon mount space 66 housing the silicon substrate mount 12. The silicon mount space 66 is the CVD space 66 where the source gas G is supplied through the source gas supply pipe 18.

The outer tube 60 is provided on an as needed basis and covers the inner tube 58. Certain clearance is provided between the outer tube 60 and the inner tube 58. The clearance is a cooling-air path 70 through which cooling air CA for cooling the case 14 passes, as described hereinbelow. The outer tube 60 is a transparent bottomed round cylinder made of quartz glass. The outer tube 60 may be a square cylinder or the like in accordance with the shapes of the inner tube 58. A quartz glass made cooling-air discharge pipe 68 is connected to the bottom (left end in the figure) of the outer tube 60 to discharge the cooling air CA to an appropriate space.

The flange 62 comprises a plurality of metal flanges. The metal flanges are stacked each other by bolts or the like. In this embodiment, four metal flanges are used. And the flange 62 suspends the outer tube 60 so as to cover the inner tube 58 and to provide the certain clearance between the outer tube 60 and the inner tube 58. The certain clearance corresponds to a cooling-air path 70. The flange 62 has a cooling-air supply hole 72 guiding the cooling air CA from outside to the cooling-air path 70.

The flange 62 has a set of cooling-water paths 74 through which cooling water CW for cooling the metal flanges passes. The cooling avoids depression of airtightness caused by expansion of the metal flange heated by the outer heater 23.

The blind flange 64 is a metal plate to seal inner space of the inner tube 58 by being attached to the flange 62. As mentioned above, the feeder bars 30a, 30b of the silicon substrate mount 12 are fixed into the blind flange 64. And the source gas supply pipe 18 and the used source gas discharge pipe 20 also are provided into the blind flange 64. The blind flange 64 has a set of cooling-water paths 74 as well as the flange 62. Gaps between the feeder bars 30a, 30b, for example, and the blind flange 64 are airproofed with gaskets or the like.

Furthermore, the blind flange 64 has a nitrogen gas supply hole 75 for supplying nitrogen gas N from a source of the nitrogen gas (N2), not shown, to the silicon mount space 66 (CVD space 66) . For rapid removing and replacing, the blind flange 64 also has a vacuum channel 76 on its contact surface for fixing to the flange 62 and a communication hole 78 communicating the vacuum channel 76 and a horse, not shown, connected to a vacuum pump. The blind flange 64 may be placed to the flange 62 with bolts or another manner.

As shown in FIG. 5 and 6, the substrate enclosing case 16 is provided between a pair of the electrode mounts 28a, 28b of the silicon substrate mount 12 within the silicon mount space 66 of the case 14 and provided on an as needed basis. The substrate enclosing case 16 limits a flow area of the source gas G from the source gas supply pipe 18 and a flow area of used source gas F not to form the thin film except on the silicon substrate S. In this embodiment, the substrate enclosing case 16 comprises a lower case 80 and an upper case 82. The silicon substrate S is put between the lower case 80 and the upper case 82.

The lower case 80 is a quartz glass made transparent box having an internal space 84 and provided on the base plate 26 between the electrode mounts 28a, 28b of the silicon substrate mount 12. The length of the lower case 80 in a longitudinal direction is slightly shorter than the length between the electrode mounts 28a, 28b; the length of the lower case 80 in a direction perpendicular to the longitudinal direction is longer than width of the silicon substrate S.

Furthermore, height of the lower case 80 is slightly shorter than a distance from the lower surface of the silicon substrate S retained by the electrode mounts 28a, 28b to a surface of the base plate 26 facing the lower surface. At both center parts of end sides of the lower case 80 in the longitudinal direction, communication slits 86 communicating the internal space 84 of the lower case 80 and outside are provided. And at center region of lower surface of the lower case 80, an opening for source gas pipe 88 is provided to surround an opening of a used source gas discharge pipe 20, as described hereinbelow. Consequently, putting the lower case 80 on the base plate 26 causes a communication between the used source gas discharge pipe 20 and outside of the lower case 80 through the internal space 84 and the communication slits 86.

A thermocouple insertion hole 87 is formed on a side surface in a longitudinal direction of the lower case 80 facing the thermocouple insertion hole 41 on the electrode mount 28b. A thermocouple 114 is inserted into the thermocouple insertion hole 87. And a transparent quartz-glass bottomed-cylindrical thermocouple sheath 89 is formed within the internal space 84 of the lower case 80. An opening of the thermocouple sheath 89 is connected to the thermocouple insertion hole 87. The end portion of the thermocouple 114 is accommodated in the thermocouple sheath 89.

The upper case 82 is a hollow quartz-glass transparent body comprising a thin-plate base 90 having a rectangle bottom surface which is almost the same shape as the upper surface of the lower case 80; and a convex part 92 on the base 90.

The convex part 92 has a smooth curved surface which is convex upward. Most of the bottom surface of the base 90 is opened. And cutout parts 94 that are wider than the width of the silicon substrate S are provided at lower portions of both side surfaces in a longitudinal direction of the base 90. A source gas supply pipe insertion hole 96 is provided on upper portion of side surface of the convex part 92. One end of the source gas supply pipe 18 is inserted into the source gas supply pipe insertion hole 96. Consequently, internal space of the source gas supply pipe 18 and the internal space 98 of the upper case 82 are communicated through the source gas supply pipe insertion hole 96.

As shown in FIG. 6, when the silicon substrate S is placed between the lower case 80 and the upper case 82, the silicon substrate S except its both ends is housed in the internal space 98 of the upper case 82. The source gas G guided into the internal space 98 of the upper case 82 through the source gas supply pipe 18 flows along the surface of the silicon substrate S. Then the source gas G is reversed and flows into the internal space 84 through the communication slit 86 of the lower case 80 following the flow out to outside of the upper case 82 through the both cutout parts 94 of the upper case 82. Finally, the source gas G flows into the used source gas discharge pipe 20 through the opening for source gas pipe 88.

Flow area for the source gas G in the CVD space 66 can be minimized by using the substrate enclosing case 16. Consequently, possibility of needless thin film formation by the source gas G except on the surface of the silicon substrate S is minimized, and possibility of contamination of the thin film formed on the silicon substrate S by metal of impurities is minimized. Specifically, isolation of the silicon substrate S from the graphite-made electrode mounts 28a, 28b by the substrate enclosing case 16 effectively avoids the metal impurities contamination. For providing the benefits of the present invention, the substrate enclosing case 16 may not be an essential. But it is preferred to provide the substrate enclosing case 16, because of the benefits as described hereinabove.

As shown in FIG.2, the source gas supply pipe 18 is a quartz-glass made pipe for supplying the source gas G from a source gas supplier 100, as described hereinafter, incidental to the CVD device 10 to the internal space 98 of the upper case 82 of the substrate enclosing case 16. As described above, one end of the source gas supply pipe 18 is connected to the source gas supply pipe insertion hole 96 on the upper case 82 of the substrate enclosing case 16 through the blind flange 64 from the right side as shown in the figure. The gap between outer surface of the source gas supply pipe 18 and the surface of the hole of the blind flange 64 is deservingly airproofed with gaskets, O-rings or the like.

The multiple source gas supply pipes 18 may be used. In case that the substrate enclosing case 16 is not used, the source gas G is supplied to a portion of the silicon mount space 66 which is airproofed with the inner tube 58, the flange 62, and the blind flange 64. At this time, it is preferred to supply the source gas G near the silicon substrate S. A baffle may be provided near one end of the source gas supply pipe 18 for even diffusion of the source gas G.

The source gas supplier 100 comprises a source gas supply pipe 102 having one end connected to a source gas, e.g. mono-silane, supplier (not shown); a purge gas supply pipe 104 having one end connected to a purge gas, or nitrogen gas, supplier (not shown); and a source gas delivery pipe 106 supplying the source gas G or the purge gas P to the source gas supply pipe 18. The source gas supply pipe 102 and the purge gas supply pipe 104 are parallelly-connected to the source gas delivery pipe 106. The source gas G or the purge gas is supplied to the source gas supply pipe 18 selectively by using valves 108 provided on each pipe. When dichlorosilane or trichlorosilane is used as the source gas G for hydrogen reduction method for silicon deposition, hydrogen gas (H2), or reducing gas, may be supplied further to the source gas G. In the method, a reducing gas supply pipe 110 may be connected to the source gas delivery pipe 106 as shown in the figure. The reducing gas supply pipe 110 is parallel to the source gas supply pipe 102 and the purge gas supply pipe 104.

The used source gas discharge pipe 20 is a quartz-glass pipe discharging the used source gas F, which is used for the CVD process, following the supply to the CVD space 66 from the source gas supply pipe 18. In this embodiment, as well as the source gas supply pipe 18, the used source gas discharge pipe 20 has one end inserted to the source gas pipe insertion hole 34 on the base plate 26 of the silicon substrate mount 12 through the blind flange 64 from right side in the figure. And the other end of the used source gas discharge pipe 20 is connected to a discharge space (not shown) for discharging the used source gas F. Multiple used source gas discharge pipes 20 may be used.

The thermometer 22 measures the temperature of the silicon substrate S placed on the silicon substrate mount 12. In this embodiment, a pyrometer 112 for noncontact measurement and a thermocouple 114 are used as the thermometer 22. Either the pyrometer 112 or the thermocouple 114 may be used. Other types of the thermometer for measuring the temperature of the silicon substrate S may be used.

The pyrometer 112 detects heat emission from the silicon substrate S through a pyrometer hole 116 provided on the outer heater 23, the outer tube 60, and the inner tube 58, as shown in FIG.3. And the pyrometer 112 measures the temperature of the silicon substrate S continuously based on a relation among the heat emission; a constant of proportion, or Stefan-Blotzmann constant; and an emissivity of the silicon substrate S.

The thermocouple 114 has one end accommodated in the thermocouple sheath 89 of the lower case 80 of the substrate enclosing case 16 through the blind flange 64, the thermocouple insertion hole 41 provided on the substrate placing table 36b of the electrode mount 28b near the blind flange 64, and the thermocouple insertion hole 87 provided on the lower case 80 of the substrate enclosing case 16. The temperature of the silicon substrate S is measured at one end of the thermocouple 114 located near the silicon substrate S.

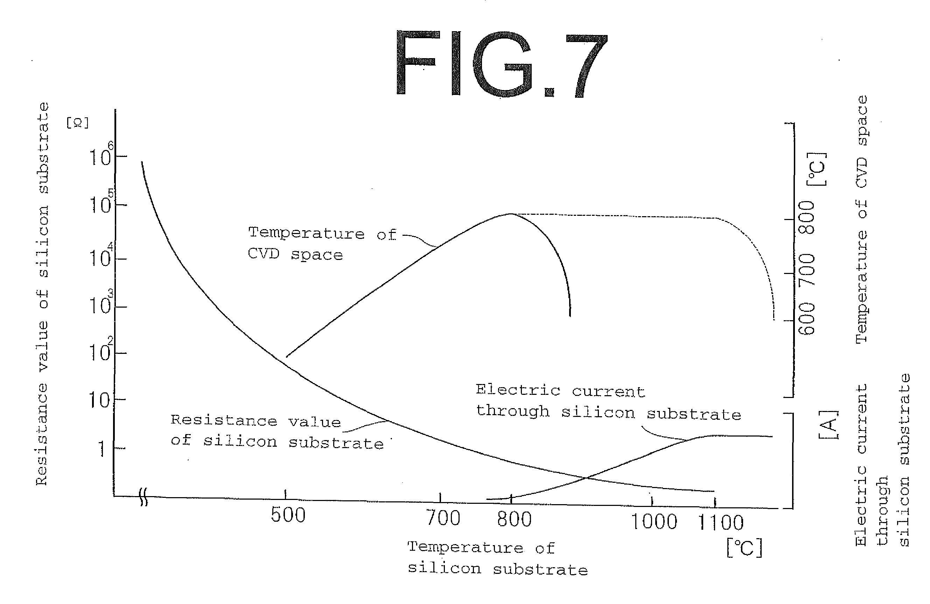

The temperature of the silicon substrate S measured with the pyrometer 112 and the thermocouple 114 is transmitted continuously to a controller 126 of the electric power-supply apparatus 24 through signal wires (not shown). As described below, when the temperature of the silicon substrate S comes up to a "turn-on temperature," the controller 126 turns on the electric power supply for heating silicon substrate 122 and starts to apply electric current to the silicon substrate S, and simultaneously stops applying electric current to the outer heater 23. In FIG.7, the "turn-on temperature" is 800 degree C, but not limited to this value.

The outer heater 23 is a cylindrical electric heater covering the outer tube 60 of the case 14 (see FIG.1 to FIG.4). In case that the outer tube 60 is not provided, the outer heater 23 covers the inner tube 58. And the inside diameter and length of the outer heater 23 are determined so that the outer tube 60 except its flange can be inserted in. A cap 118 made of insulation material, e. g. ceramic wool, is attached to an end of the outer heater 23 of the opposite side of the end where the outer tube 60 is inserted.

The electric power-supply apparatus 24 is for supplying electric power to the electrode mounts 28a, 28b of the silicon substrate mount 12. And the electric power-supply apparatus 24 comprises: a feeder for heating silicon substrate 120; a feeder for outer heater 121; an electric power supply for heating silicon substrate 122; an electric power supply for outer heater 124; and a controller 126.

The feeder for heating silicon substrate 120 is a pair of lead wires; each of the lead wires has one end electrically connected to the electric power supply for heating silicon substrate 122 and the other end electrically connected to the feeder bars 30a, 30b respectively.

The feeder for outer heater 121 is a pair of lead wires; each of the lead wires has one end electrically connected to the electric power supply for outer heater 124 and the other end electrically connected to the terminal (not shown) of the outer heater 23 respectively.

The electric power supply for heating silicon substrate 122 supplies electric power for heating the silicon substrate S to the temperature at which the CVD process can be started by applying an electric current to silicon substrate S. Capacity of the electric power supply for heating silicon substrate 122 is selected appropriately based on a supply voltage or electric current level set according to the size of the silicon substrate S.

The electric power supply for outer heater 124 applies the electricity to the outer heater 23 for heating to predetermined temperature. Capacity of the electric power supply for outer heater 124 is selected appropriately based on a supply voltage or electric current level set according to the capacity of the outer heater 23.

The controller 126 controls temperature of the silicon substrate S by operating the electric power supply for heating silicon substrate 122 and the electric power supply for outer heater 124 based on the temperature of silicon substrate S measured by the thermometer 22, or the pyrometer 112 or the thermocouple 114 in this embodiment.

In this embodiment, the electric power supply for heating silicon substrate 122 is turned on when the temperature of the silicon substrate S reached predetermined temperature. The relations with the temperature and the resistance value of the silicon substrate S are examined preliminarily. The method of determination of the timing for applying the electric power is not limited to this. The electric power supply for heating silicon substrate 122, including the electric power supply for outer heater 124, may be turned on when the silicon substrate S is at normal temperature, or when the outer heater starts to heat the silicon substrate S. In this case, the application of electricity to the silicon substrate S is started automatically by decrease in the resistance value of the heated silicon substrate S. Furthermore, the electric power supply for heating silicon substrate 122 may be turned on based on elapsed time from the electric power supply for outer heater 124 is on or based on the resistance value of the silicon substrate S.

The controller 126 turns off the electric power supply for outer heater 124 and the outer heater 23, and at the same time start the application of electricity to the silicon substrate S. A timing to stop outer heater 23 to reduce the temperature of CVD space 66 may be set to the timing where the temperature of the silicon substrate S reaches the temperature at which the CVD process can be started (e.g., 1,100 degrees C). But it is necessary for the silicon substrate S to keep the temperature at which the CVD process can be started by adjusting the electric current level applied to the silicon substrate S: this prevents the temperature of the silicon substrate S from raising too high until the temperature in the CVD space 66, particularly inner wall surface temperature of the inner tube 58 in the case 14, decreases to predetermined temperature following stop of the outer heater 23.

The procedure in the CVD processing of the silicon substrate S using the CVD device 10 of this embodiment is explained as follows.

First, the blind flange 64 is dismounted from the flange 62. Then, the silicon substrate mount 12 is pulled out from the silicon mount space 66 of the case 14. The blind flange 64 is easily dismounted because adhesion strength between the blind flange 64 and the flange 62 decreases by decrease vacuum level at the vacuum channel 76 of the blind flange 64 following turn off of a vacuum pump (not shown). The blind flange 64 is easily dismounted by stopping a vacuum pump (not shown). Because of a decrease in vacuum level at the vacuum channel 76 of the blind flange 64, a bonding strength between the blind flange 64 and the flange 62 decreases.

The upper case 82 of the substrate enclosing case 16 is dismounted from the silicon substrate mount 12 pulled out from the silicon mount space 66. Then, the both ends of the silicon substrate S are attached to the substrate set-in recesses 39 of the substrate placing tables 36a, 36b. After that, the silicon substrate S is fixed to the electrode mounts 28a, 28b with the pivot members 46 and the substrate push screws 50 by using a pair of the substrate holders 38a, 38b.

The both ends of the silicon substrate S is retained with a pair of the electrode mounts 28a, 28b. Then, the upper case 82 is stacked to the lower case 80; the silicon substrate S is arranged between the lower case 80 and the upper case 82. The mounting of the silicon substrate S is completed.

After the mounting of the silicon substrate S is completed, the silicon substrate mount 12 is inserted into the silicon mount space 66 of the case 14. While the blind flange 64 is pressed to the flange 62, the blind flange 64 is closely fixed to the flange 62 by rise of the vacuum level at the vacuum channel 76 of the blind flange 64 by using the vacuum pump. Then the silicon mount space, or the CVD space, 66 of the case 14 is sealed and the silicon substrate mount 12 is fixed at predetermined position.

After the CVD space 66 is sealed, the CVD space 66 is purged with nitrogen gas supplied through the nitrogen gas supply hole 75 on the blind flange 64 and/or the source gas supply pipe 18. An air in the CVD space 66 flows into the internal space 84 of the lower case 80 of the substrate enclosing case 16 through the communication slit 86 of the lower case 80. Then the air is discharged through the opening for source gas pipe 88 and the used source gas discharge pipe 20.

After the purge of the CVD space 66 is completed, the electric power supply for outer heater 124 is turned on by the controller 126 of the electric power-supply apparatus 24.

The outer heater 23 is heated by the electric current from the electric power supply for outer heater 124 in operation. Then the silicon substrate S and the whole silicon substrate mount 12 are heated with the heat, mainly radiation heat, from the outer heater 23.

As shown in FIG. 7, when the temperature of the silicon substrate S rises, the resistance value between both ends in the silicon substrate S concerned decreases rapidly. At around 800 degrees C, the resistance value of the silicon substrate S becomes around one Ω. At the timing that the silicon substrate S becomes around one Ω, the electric power supply for heating silicon substrate 122 is turned on to start to apply electric current and the electric power supply for outer heater 124 is turned off simultaneously. The application of the electric current may be started at around 700 degrees C, because the resistance value becomes a few Ω at the temperature. In this embodiment, when the temperature of the silicon substrate S reaches the temperature that the CVD process can be started, the cooling air CA is supplied to the cooling-air path 70 through the cooling-air supply hole 72 in the flange 62 of the case 14 for cooling rapidly the atmosphere temperature within the CVD space 66. This results in that the temperature of the silicon substrate mount 12 and the silicon mount space 66 decreases rapidly, but the temperature of the silicon substrate S does not decrease, because Joule heat is generated in the silicon substrate S by the electric current from the electric power supply for heating silicon substrate 122.

After the electric current is applied to the silicon substrate S, the controller 126 increases the electric current from the electric power supply for heating silicon substrate 122. Then the temperature of the silicon substrate S becomes larger than the temperature of the CVD space 66. The heating of the silicon substrate S to the temperature, e. g. 1,100 degrees C, that the CVD process can be started is confirmed. And the sufficient decrease in temperature of the CVD space 66, specifically the inner wall temperature of the inner tube 58 of the case 14, and the silicon substrate mount 12 is confirmed. After that, the source gas G is supplied into the internal space 98 of the upper case 82 of the substrate enclosing case 16 from the source gas supply pipe 18 by opening the valve 108 on the source gas supply pipe 102 connected to a supply source of the source gas G, or a silane supply source in this embodiment.

The source gas G supplied to the internal space 98 in the upper case 82 is thermally decomposed on the surface of the silicon substrate S heated to the temperature that the CVD process can be started. The silicon (Si) generated by the thermal decomposition is deposited on the surface of the silicon substrate S. The silicon thin film is produced with the deposited silicon.

The thermally-decomposed used source gas F flows into the used source gas discharge pipe 20 through the cutout part 94 of the upper case 82, the communication slit 86 of the lower case 80, and the internal space 84 in the lower case 80. Finally, the used source gas F is discharged outside of the CVD device 10 through the used source gas discharge pipe 20.

After forming the thin film having a required thickness, the valve 108 on the source gas supply pipe 102 is closed. Then the valve 108 on the purge gas supply pipe 104 is opened, and the nitrogen gas N is supplied into the CVD space 66 through the nitrogen gas supply hole 75 of the blind flange 64. The result in that the whole CVD space 66 is purged with the nitrogen gas N. The nitrogen gas N may be supplied through the purge gas supply pipe 104 or the nitrogen gas supply hole 75 selectively.

The application of the electric current to the silicon substrate S is stopped, when the nitrogen gas N is filled within the CVD space 66. The supply to the outer heater 23 has already stopped at this time. Then, the temperature of the silicon substrate S decreases rapidly to the normal temperature, or the temperature near the nitrogen gas N temperature. The decrease in temperature of the silicon substrate S to normal temperature is confirmed with the thermometer 22. After that, the nitrogen gas N is stopped. Then the CVD process is completed.

As described above, the CVD device 10 of this embodiment lowers the resistance value of the silicon substrate S to an applicable value, for example 600 to 800 degrees C, by heating the silicon substrate S with the outer heater 23 provided outside the case 14 and heats only the silicon substrate S by applying electrical current to the temperature at which the CVD process can be started, for example a temperature for the epitaxial film forming process; lowers the atmosphere temperature in the CVD space 66 to e.g. 600 degrees C by stopping the outer heater 23; and injects the source gas G into the CVD space 66.

According to this embodiment, the thin film is formed on the surface of the silicon substrate S heated to the temperature that the CVD process can be started by thermal decomposition of the source gas G near the surface of the silicon substrate S, and the thin film is not formed at a needless area by lowering the temperature of the members, for example the case 14 and the electrode mounts 28a, 28b, except the silicon substrate S.

Furthermore, it is enough to heat only the silicon substrate S to the temperature at which the CVD process can be started. In other words, required heating capacity can be smaller than that for the conventional CVD devices, with reduction of required heating time. Consequently, CVD process time can be shortened.

Furthermore, the smaller the required heating capacity is, the smaller the size of an electric power-supply apparatus supplying to the outer heater 23 is. This results in that the size of the CVD device 10 is minimized.

Any judgment methods for determining timing for applying the current to the silicon substrate S can be selected. As this embodiment, the application of the current to the silicon substrate S may be started automatically by keeping the application of voltage across both ends of the silicon substrate S before the heating to the silicon substrate S with the outer heater 23 is started. The heated silicon substrate S shows a lowered resistance value, so that the application of the current is started automatically at a certain temperature, or a certain resistance value. The temperature that the electric current from the electric power supply for heating silicon substrate 122 can be applied depends on the voltage applied to the silicon substrate S. The higher the voltage is, the lower, e. g. lower than 800 degrees C, the temperature that the electric current can be applied is. And the application of the current may be started based on elapse time from an activation of the outer heater 23 or the resistance value of the silicon substrate S.

Timing for stopping the outer heater 23 for decreasing the atmosphere temperature of the CVD space 66 may be simultaneous with the timing for starting the application of the current to the silicon substrate S. The outer heater 23 may be stopped, when the temperature of the silicon substrate S rises to the temperature at which the CVD process can be started, as shown in a dash line in FIG.7. In the latter case, the current through the silicon substrate S must be adjusted so as to keep the temperature that the CVD process can be started until the time the atmosphere temperature of the CVD space 66 is lowered to a predetermined temperature after stopping the outer heater 23.

As described above, when silicon epitaxial film is produced on the silicon substrate S using silane (SiH4) gas as the source gas G with the CVD device 10 in this embodiment, the thermal decomposition (SiH4 to Si + 2H2) and the production of the mono-silicon thin film is occurred only on the surface of the silicon substrate S. Consequently, the crystalline silicon is not adhered to any other surfaces, e.g. inner surface of the outer tube 60, but a small amount of power amorphous reaction product adheres.

To remove such a reaction product, a mixed gas of hydrogen chloride (HCl) and hydrogen (H2) is supplied to the CVD space 66 through the source gas supply pipe 18 or the nitrogen gas supply hole 75 following sealing of the CVD space 66 by fixing the blind flange 64 only to the flange 62 without mounting the silicon substrate S on the silicon substrate mount12 and raising of the atmosphere temperature up to approximately 1,200 degrees C with the outer heater 23. When the source gas supply pipe 18 is used, the end of the source gas supply pipe 18 is disconnected from the source gas supply pipe insertion hole 96 of the upper case 82 of the substrate enclosing case 16 for filling the whole CVD space 66 with the mixed gas.

The hydrogen chloride in the mixed gas supplied to the CVD space 66 reacts to and removes the reaction products and impurities included in the silane, or the source gas G, for the CVD process.

According to the CVD device 10 in this embodiment, the crystalline silicon is not adhered to any surfaces except the silicon substrate S, but only a small amount of powder amorphous reaction product adheres. As described above, the reaction product can be removed easily; any marks of removal, e.g. the devitrification of quartz glass, are not formed unlike in the case of a chemical removal of the crystalline silicon. Consequently, a cleaning of the CVD space 66 becomes quite easy.

## Claims

1. A method for CVD processing, comprising the steps of:
fixing both ends of a silicon substrate S to a pair of electrode mounts (28a), (28b) spaced out within a CVD space (66) in a case (14);
lowering a resistance value of the silicon substrate (S) by raising a temperature of the silicon substrate (S) with heat from an outer heater (23) provided outside the case (14);
heating the silicon substrate (S) to a temperature at which the CVD process can be started by applying electrical current through the electrode mounts (28a), (28b), and lowering an atmosphere temperature in the CVD space (66) by stopping the outer heater (23); and
forming a thin film on a surface of the silicon substrate (S) by injecting source gas (G) into the CVD space (66), when the silicon substrate (S) is heated to the temperature at which the CVD process can be started and the atmosphere temperature in the CVD space (66) is lowered to a predetermined temperature.

2. The method for CVD processing according to claim 1, wherein the voltage across the silicon substrate (S) is applied simultaneously with heating the silicon substrate (S) with the outer heater (23).

3. A CVD device (10) comprising:
a case (14) having a CVD space (66) inside and being connected to a source gas supply pipe (18) supplying a source gas to the CVD space (66);
an outer heater (23) provided outside of the case (14);
a pair of electrode mounts (28a), (28b) spaced out within the CVD space (66) and retaining both ends of a silicon substrate (S) for applying the CVD process; and
an electric power-supply apparatus (24) applying current to the silicon substrate (S) through the electrode mounts (28a), (28b) and supplying electric power to the outer heater (23),
wherein the electric power-supply apparatus (24) has a controller (126) which heats electrically the silicon substrate (S) to certain temperature at which the CVD process can be started by heating the silicon substrate (S) with the outer heater (23) following reduction of resistance value of the silicon substrate (S), and reduces an atmosphere temperature of the CVD space (66) by stopping the outer heater (23) before a supply of source gas (G) to the CVD space (66) through the source gas supply pipe (18).

4. The CVD device (10) according to claim 3, wherein the controller (126) applies a voltage across the silicon substrate (S) when the silicon substrate (S) begins to be heated with the outer heater (23).

5. The CVD device (10) according to claim 3, further comprising a thermometer (22) measuring temperature of the silicon substrate (S) and transmitting the measured temperature to the controller (126),
wherein the controller (126) begins to apply the current through the silicon substrate (S), when the silicon substrate (S) reaches at a certain temperature.
